# EUROPEAN PATENT APPLICATION

(11) **EP 3 415 403 A1**
(43) Date of publication of application: **19.12.2018**
(21) Application number: 17176095.2
(22) Date of filing: 14.06.2017
(51) Int. Cl.: B62D 5/04

(54) **CURRENT SENSE CIRCUIT ARRANGEMENT AND METHOD FOR SENSING A CURRENT**

(71) Applicant: AMS AG, 8141 Unterpremstätten (AT)
(72) Inventor: Matamura, Atsushi, Tokyo Tokyo 150-0013 (JP)
(74) Representative: Epping - Hermann - Fischer

(57) **Abstract**

The invention concerns a current sense circuit arrangement for a load (1) arranged in a bridge branch (53) coupled between two legs (51, 52) of an H-bridge comprising two highside switching transistors (S1, S2) and two low-side switching transistors (S3, S4). The current sense circuit arrangement comprises a first resistor (10) and a second resistor (20), the first resistor (10) being arranged upstream of the load (1) or load connectors (5, 6), between which the load (1) is connectable, in the bridge branch, the second resistor (20) being arranged downstream of the load (1) or load connectors, between which the load (1) is connectable, in the bridge branch. The current sense circuit arrangement further comprises a summing means for adding a first voltage across the first resistor (10) and a second voltage across the second resistor (20).

## Description

The invention concerns a current sense circuit arrangement for a load arranged in a bridge branch of an H-bridge and a method for sensing a current in an H-bridge.

A switching driver allows applying a voltage across a load in either direction. Such a load may be an electric motor whose movement depends on the direction of the applied voltage. A voice coil motor (VCM) is a simple type of an electric motor. One embodiment of a switching driver for an electric motor is an H-bridge which allows a DC motor to run forwards or backwards.

For a switching driver, a current sense circuit may be used for sensing the current flow. In most cases, the accuracy requirement is not so high. It is also difficult to handle a wide range of square wave signals so that a precise continuous measurement is difficult to implement.

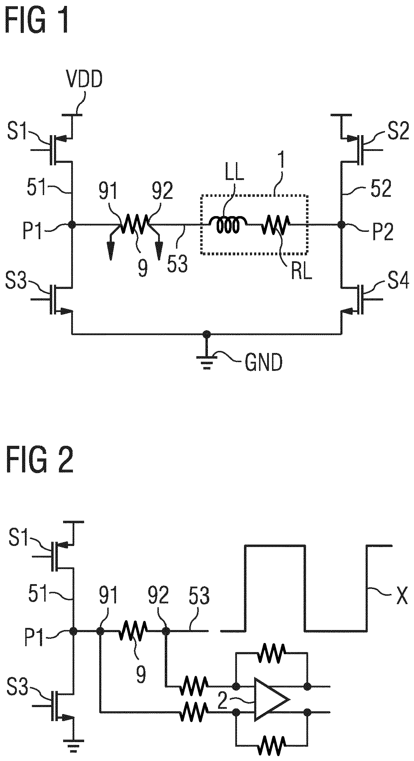

A series resistance that is coupled in series to the load at the output node (as shown in Figure 1) of a switching driver is preferred in order to provide a precise continuous current measurement; unless there are dead times, non-load current can be measured. The problem of the series resistance measurement approach is handling square-wave input common-mode swing.

There is a desire for a more precise continuous current sensing.

The invention concerns a current sense circuit arrangement for a load arranged in a bridge branch coupled between two legs of an H-bridge comprising two high-side switching transistors and two low-side switching transistors. The current sense circuit arrangement comprises a first resistor and a second resistor, through which a current to be sensed travels. The first resistor is arranged upstream of the load or load connectors, between which the load is connectable, in the bridge branch. The second resistor is arranged downstream of the load or load connectors, between which the load is connectable, in the bridge branch. The current sense circuit arrangement further comprises a summing means for adding a first voltage across the first resistor and a second voltage across the second resistor. The load may be part of the circuit arrangement or not. In the latter case the connectors are suitable for coupling a load thereto and between the first and second resistors.

The first resistor has a first terminal and a second terminal, and the second resistor has a first terminal and a second terminal. The second terminal of the first resistor is coupled with the load or one of the load connectors. The first terminal of the second resistor is connected with the load or the other one of the load connectors. Coupling two components may be performed via one or more further components arranged inbetween or via a direct conductive connection; the latter may also be called connecting.

The summing means comprises an amplifier. The new measurement approach can be explained as follows: One series sense resistor is splitted and driven differentially by binary modulation. By using this measurement structure, square wave common-mode is cancelled out at amplifier inputs. There is no need for a bulky low-pass filter. A very high common-mode rejection ratio (CMRR) configuration, which can handle square waves, is not required any more.

The current sense amplifier front-end requirement is greatly relaxed by splitting one sense resistor into two ones. The requirement for a high accuracy implementation using one conventional series resistor is tough (just mentioning e.g. rail-to-rail input, stable offset over entire input range, square wave input handling, bulky low-pass filter). However, with splitting one sense resistor, the amplifier only sees differential components and does not have to handle high frequency common-mode signals. A standard amplifier can be used for high precision current measurements.

In one embodiment of the invention, a first potential node, which is arranged in a first leg of the H-bridge, comprises one of the two high-side switching transistors and one of the two low-side switching transistors. A second potential node, which is arranged in a second leg of the H-bridge, comprises the other one of the two high-side switching transistors and the other one of the two low-side switching transistors. The first terminal of the first resistor is connected with the first potential node and the second terminal of the second resistor is connected with the second potential node; thereby the first and second resistors and the load form the bridge branch of the H-bridge.

Preferably, the first resistor has the same or nearly the same resistance value as the second resistor, which enables cancelling out common-mode disturbances.

In one embodiment, the summing means comprises a first summing node coupled with the first terminals of the first and second resistors and a second summing node coupled with the second terminals of the first and second resistors. The voltages dropping across the first and second resistors are added by means of the summing nodes.

The summing means further comprises a differential amplifier having first and second input terminals that are coupled with the first and second summing nodes or embodied as the first and second summing nodes. The differential amplifier has a first output and a second output. The amplifier provides an output voltage proportional to the summed voltage drops across the first and second resistors. In other words, the differential amplifier is suitable for providing a amplified difference of the sum of voltages at the first terminals and the sum of voltages at the second terminals.

A third resistor is coupled between the first terminal of the second resistor and the first summing node. A fourth resistor is coupled between the first terminal of the first resistor and the first summing node. A fifth resistor is coupled between the second terminal of the first resistor and the second summing node. A sixth resistor is coupled between the second terminal of the second resistor and the second summing node. The resistors convert the voltages at the terminals of the first and second resistors into proportional currents, which may be summed at the summing nodes.

The first input terminal of the differential amplifier is coupled with the first output via a seventh resistor. The second input terminal is coupled with the second output via an eighth resistor. Thus, the output voltage is proportional to the voltage difference at the input terminals. In other words, the amplifier provides a amplified difference or amplified differences of the input voltages.

The current sense circuit arrangement arranged in an H-bridge may be comprised by a loop arrangement. An output of the summing means is coupled via an error amplifier means to a pulse-width modulator means controlling the switches of the H-bridge in dependence of the output of the summing means. The loop arrangement enables controlling the load by means of the H-bridge in dependence on the sensed current through the load.

A method for sensing a current in an H-bridge refers to a bridge branch that is arranged between two legs of the H-bridge comprising two high-side switching transistors and two low-side switching transistors, a first resistor being arranged upstream of a load in the bridge brange of the H-bridge and a second resistor being arranged downstream of the load in the bridge branch. The method comprises:
- detecting a first voltage across the first resistor,
- detecting a second voltage across the second resistor,
- summing the first voltage across the first resistor and the second voltage across the second resistor.

The first resistor has a first terminal and a second terminal, and the second resistor has a first terminal and a second terminal. The second terminal of the first resistor is coupled with the load. The first terminal of the second resistor is coupled with the load. Summing includes summing the voltages at the first terminals, summing the voltages at the second terminals and providing a amplified difference of the sum of the voltages at the first terminals and the sum of the voltages at the second terminals. These steps are performed by the third to eighth resistors and the differential amplifier.

Summing the voltages at the first terminals includes converting the voltages into proportional currents and adding them as well as summing the voltages at the second terminals includes converting the voltages into proportional currents and adding them. Providing a amplified difference of the sums includes converting the added currents into proportional voltages and providing the amplified difference of the proportional voltages by means of a differential amplifier. The components of the sense means convert the voltage drops across the first and second resistors in to currents, sum them and provide a voltage proportional to the difference of the sums.

Non-limiting, exemplary embodiments of the invention will now be described with reference to the accompanying drawings, in which:
Figure 1 shows a conventional embodiment of an H-bridge.
Figure 2 shows a part of the H-bridge of Figure 1 further comprising a differential amplifier.
Figures 3a, 3b and 3c illustrate alternative arrangements for current sensing in H-bridges.
Figure 4 shows an embodiment of a current sense circuit arrangement according to the invention.
Figures 5a and 5b illustrate voltages including terminal voltage, differential voltage and common-mode voltage.
Figure 6 shows an embodiment of a loop configuration including the current sense circuit arrangement of Figure 4.

Figure 1 shows a conventional embodiment of an H-bridge comprising a first switching transistor S1, a second switching transistor S2, a third switching transistor S3 and a fourth switching transistor S4. The first and second switching transistors S1, S2 are high-side switching transistors being connected with a supply voltage node VDD. The third and fourth switching transistors S3, S4 are low-side switching transistors being connected with ground GND. The first and third switching transistors S1, S3, which are connected in series, form one leg 51 of the H-bridge. The second and fourth switching transistors S2, S4, which are connected in series form the other leg 52 of the H-bridge. A bridge branch 53, on which a load 1 is arranged, is connected between the legs 51, 52. The load 1 may be a motor indicated by an equivalent circuit consisting of a resistor RL and an inductor LL in series.

The motor may be driven by pulse-width modulation creating differential wave forms to control the current flow through the load 1. Switching ON the first and fourth switching transistors S1, S4 and switching OFF the second and third switching transistors S2, S3 enables a current flow through the branch bridge 53 in one direction. Switching ON the second and third switching transistors S2, S3 and switching OFF the first and fourth switching transistors S1, S4 enables a current flow through the branch bridge 53 in the other direction.

The current that travels through the load 1 may be detected by means of a resistor 9 connected in series with the load 1 in the bridge branch 53. A voltage that is proportional to the current through the resistor 9 drops across the resistor 9 and may be detected at the resistor's terminals 91, 92, which is indicated by the arrows.

The legs 51, 52 may form a switching driver for driving the load 1, which is couplable between connectors of the switching driver. The connectors are arranged at potential nodes P1, P2 between the switching transistors S1, S3, S2, S4 of each leg 51, 52. They are formed in such a manner that the components 1, 9 of the bridge branch 53 are connectable between them.

Figure 2 shows a part of the H-bridge of Figure 1 further comprising a differential amplifier 2 coupled with resistors and the terminals 91, 92 of the resistor in the bridge branch 53 for providing an output voltage that is proportional to the voltage drop across the resistor 9. Providing the series resistor 9 at the connector that serves as output node P1 of the H-bridge circuit causes large common-mode swings, as indicated by the signal curve X, which requires a bulky low-pass filter (LPF), a divider and a high common-mode rejection ratio (CMRR).

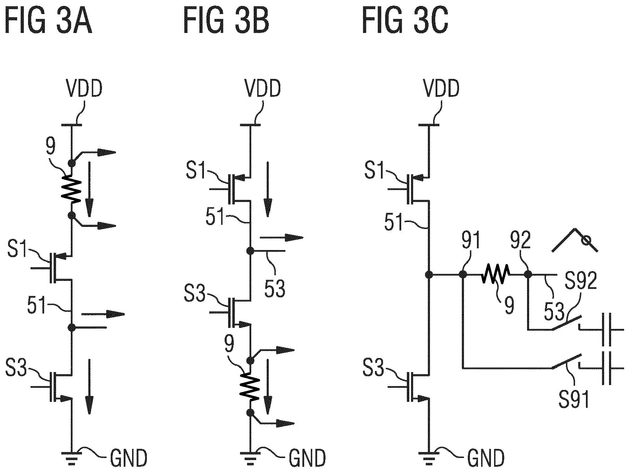

Figures 3a, 3b and 3c show alternative arrangements for current sensing in H-bridges. Figure 3a shows one leg 51 of an H-bridge and a part of the bridge branch 53. A restistor 9 for current sensing is provided between a voltage supply node VDD and the high-side switching transistors. The sense line is clearly shown and indicated by arrow-shaped taps. The arrows indicate possible currents that may travel through the circuit. Figure 3b shows one leg 51 of an H-bridge and a part of the bridge branch 53, where a restistor 9 for current sensing is provided between ground and the low-side switching transistors. This kind of current sensing is precise and stable against common-mode interferences but only during a specific period. It allows e.g. good peak current detection.

Another way of current sensing (not illustrated in the Figures) uses the drain-source voltage of one or several switching transistors. However, sensing the current by monitoring this voltage is not precise.

Figure 3c illustrates a sampling method for current sensing where the voltage at one of the resistor terminals 91, 92 of a series resistor 9 in the bridge branch 53 may be detected by means of switches S91, S92 connected with the resistor's terminals 91, 92. However, such a sampling method loses continuous information and requires a bullky low-pass filter.

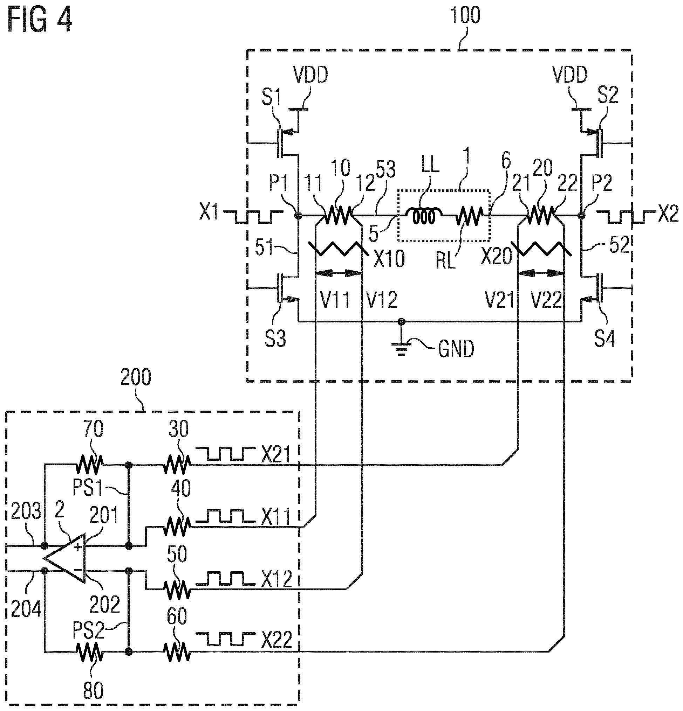

Figure 4 shows an embodiment of a current sense circuit arrangement. An H-bridge block 100 includes an H-bridge and sensing means that comprises two resistors, which are a first resistor 10 and a second resistor 20. A sense amplifier block 200 comprises a differential amplifier 2.

The H-bridge comprises a first switching transistor S1, a second switching transistor S2, a third switching transistor S3 and a fourth switching transistor S4. The first and second switching transistors S1, S2 are high-side switching transistors connected with a supply voltage node VDD. The third and fourth switching transistors S3, S4 are low-side switching transistors connected with ground GND. The first and third switching transistors S1, S3, which are connected in series, form a first leg 51 of the H-bridge. The second and fourth switching transistors S2, S4, which are connected in series, form a second leg 52 of the H-bridge.

The switching transistors S1, S2, S3, S4 may be embodied as same type transistors or comprise different types of transistors. In this embodiment, the first and second switching transistors S1, S2 are PMOS (p-channel metal-oxide semiconductors) and the third and fourth switching transistors S3, S4 are NMOS (n-channel metal-oxide semiconductors). The switching transistors of alternative embodiments may be all NMOS or all PMOS.

A bridge branch 53 is coupled between potential nodes P1, P2, which are located between the switching transistors S1, S2, S3, S4 of the first and second legs 51, 52.

The switching transistors S1, S2, S3, S4 may be controlled by a control device (not shown in Figure 4), which may be e.g. a pulse-width modulation (PWM) control device. When the first and fourth switching transistors S1, S4 are ON and the second and third switching transistors S2, S3 are OFF, a current travels through the bridge branch 53 from the first node P1 to the second node P2. When the first and fourth switching transistors S1, S4 are OFF and the second and third switching transistors S2, S3 are ON, the current travels in the reverse direction through the bridge branch 53.

The bridge branch 53 comprises a load 1 and the first resistor 10 and the second resistor 20. The load 1 may be a voice coil motor (VCM) indicated by an equivalent circuit including a resistor RL and an inductor LL connected in series. A current to be sensed travels trough the load 1 along the bridge branch 53. The first resistor 10 and the second resistor 20 are arranged upstream and downstream of the load 1 in the bridge branch 53. The first resistor 10 has a first terminal 11 coupled to the first potential node P1 and a second terminal 12 coupled to the load 1. The second resistor 20 has a first terminal 21 coupled to the load 1 and a second terminal 22 coupled to the second potential node P2.

The legs 51, 52 and the first and second resistors 10, 20 may be embodied as a module or an integrated circuit wherein connectors 5, 6 for connecting the load 1 are provided at the second terminal 12 of the first resistor 10 and the first terminal 21 of the second resistor 20. Such a module or integrated circuit may be comprised by a switching driver for controlling the load 1.

Alternatively, the legs 51, 52 may be embodied as a module or an integrated circuit wherein connectors, which are arranged at the potential nodes P1 and P2 in Figure 4, are provided between the first and third switching transistors S1, S3 and between the second and fourth switching transistors S2, S4 for connecting the series connection of the first and second resistors 10, 20 and the load 1 forming the bridge branch 53 between the legs 51, 52. It should be mentioned that in such an embodiment connectors for connecting the load 1 may be provided at the second terminal 12 of the first resistor 10 and the first terminal 21 of the second resistor 20.

When the current to be sensed travels through the bridge branch 53, a voltage proportional to the resistance of the first resistor 10 and the current through the first resistor 10; the voltage dropping between the first and second terminals 11, 12. Furthermore a voltage proportional to the resistance of the second resistor 20 and the current through the second resistor 20; the voltage dropping between the first and second terminals 21, 22. The resistances of the first and second resistors 10, 20 are equal or nearly equal; thereby a same current through the first and second resistors 10, 20 causes same voltage drops.

The amplifier sense block 200 comprises the differential amplifier 2 having a first amplifier input 201, a second amplifier input 202, a first amplifier output 203 and a second amplifier output 204. The amplifier 2 is suitable for providing an output voltage between the amplifier outputs 203, 204, which is an amplified voltage of the voltage applied between the amplifier inputs 201, 202. The amplifier sense block 200 further comprises a third resistor 30, a fourth resistor 40, a fifth resistor 50, a sixth resistor 60, a seventh resistor 70 and an eighth resistor 80, which are coupled to the amplifier 2.

The third resistor 30 is coupled between the first terminal 21 of the second resistor 20 and a potential node forming a first summing node PS1. The fourth resistor 40 is coupled between the first terminal 11 of the first resistor 10 and the first summing node PS1. The fifth resistor 50 is coupled between the second terminal 12 of the first resistor 10 and a potential node forming a second summing node PS2. The sixth resistor 60 is coupled between the second terminal 22 of the second resistor 20 and the second summing node PS2. The sum of currents flowing into the first summing node PS1, which is a stable summing junction, is equal to the sum of currents flowing out of that node. Usually the voltage at the first summing node PS1 is about half of the supply voltage applied to the supply voltage node VDD. The sum of currents flowing into the second summing node PS2, which is a stable summing junction, is equal to the sum of currents flowing out of that node.

The first and second summing nodes PS1, PS2 are connected with the first and second amplifier inputs 201, 202 or embodied as the first and second amplifier inputs 201, 202. In the latter case, the third and fourth resistors 30, 40 are connected to the first amplifier input 201 just as the fifth and sixth resistors 50, 60 are connected to the second amplifier input 202.

The first amlifier input 201 is coupled to the first amplifier output 203 via the seventh resistor 70. The second amplifier input 202 is coupled to the second amplifier output 204 via the eighth resistor 80.

Providing the voltage at the amplifier outputs 203, 204 works as follows. The voltage at the first terminal 21 of the second resistor 20 is converted by means of the third resistor 30 into a proportional current travelling into the first summing node PS1. The voltage at the first terminal 11 of the first resistor 10 is converted by means of the fourth resistor 40 into a proportional current travelling into the first summing node PS1. The currents are added by the summing node PS1. The summed currents are converted into a voltage by the seventh resistor, which causes a voltage drop proportional to the summed currents, resulting in a voltage at the first amplifier output 203. The voltages at the second terminal 12 of the first resistor 10 and the second terminal 22 of the second resistor 20 are converted into an output voltage at the second amplifier output 204 by means of the fifth, sixth and eighths resistors 50, 60, 80 and the amplifier 2 in an equivalent manner. Thus, the voltage between the amplifier inputs 201, 202 is amplified and provided between the amplifier outputs 203, 204.

The amplifier 2 provides an output voltage that is proportional to the difference between the sum of the voltages V11, V21 applied at the first terminals 11, 21 of the first and second resistors 10, 20 and the sum of the voltages V12, V22 applied at the second terminals 12, 22 of the first and second resistors 10, 20, which means (V11 + V21) - (V12 + V22). In other words, the amplifier 2 amplifies the sum of the voltage drop between the terminals 11, 12 of the first resistor 10 and the voltage drop between the terminals 21, 22 of the second resistor 20, which means (V11 - V12) + (V21 - V22). A driving current for operating the load 1 that travels from the first to the second nodes P1, P2 or vice versa may be sensed by the circuit and causes a voltage proportional to the driving current at the amplifier outputs 203, 204.

However, during operation the switching processes may cause square wave swings as a form of common-mode interferences that apply at the first and second potential nodes P1, P2 and travel towards the load 1.

The signals resulting from square wave swings and their temporal progress at the first and second terminals 11, 12, 21, 22 of the first and second resistors 10, 20 are indiciated by the curves X11, X12, X21, X22 located on the connections to the terminals 11, 12, 21, 22. The signals are similar for the first terminal 11 of the first resistor 10 and the second terminal 22 of the second resistor 20 as well as for the second terminal 12 of the first resistor 10 and the first terminal 21 of the second resistor 20.

In this embodiment, the voltage applied at the first potential node P1 and the first terminal 11 of the first resistor 10 is inverse to the voltage applied at the second potential node P2 and the second terminal 22 of the second resistor 20 as indicated by the terminal voltage curves X1 and X2, respectively. The curves X1, X2, X11, X12, X21, X22 show a PWM square wave polarity.

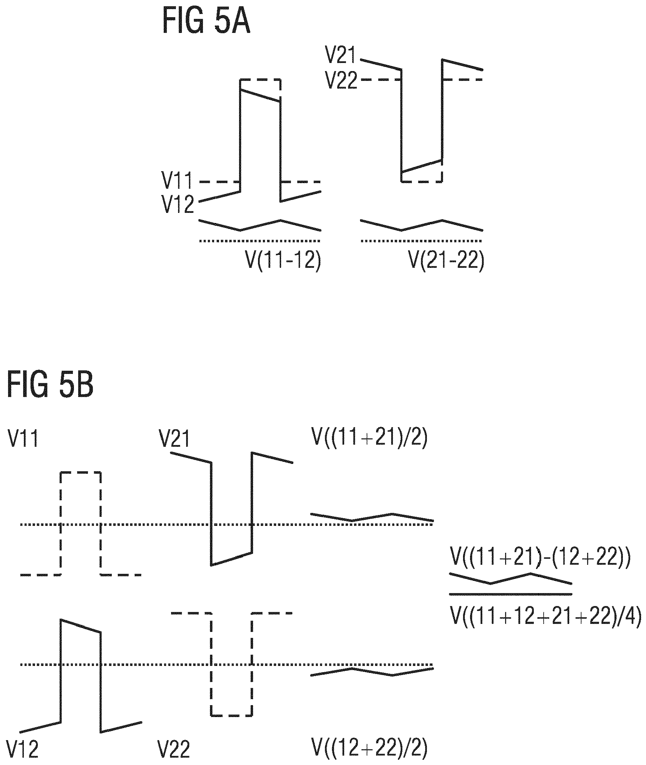

Figure 5a shows the terminal voltages V11, V12 at the first and second terminals 11, 12 of the first resistor 10 as well as the terminal voltages V12, V22 at the first and second terminals 21, 22 of the second resistor 20. The voltages at the load-side terminals 12, 21 are voltage dropped respect to the ones at the leg-side terminals 11, 22, which is measured current resistor voltages V(11-12), V(21-22) across the terminals of each resistor 10, 20, which are also shown in Figure 5a. Going back to Figure 4, which also shows resistor voltage waveform curves X10, X20, tapping the terminals 11, 12, 21, 22 of the resistors 10, 20 allows current measurent wherein the resistor voltages depends on the resistances R10, R20 of the first and second resistors 10, 20 and the current ILOAD through the load 1: V10=ILOAD*R10 and V20=ILOAD*R20. Keeping in mind that the first and second resistors 10, 20 may be considered as splitted resistor RSNS, these equations can also be written as V10=ILOAD*RSNS/2 and V20=ILOAD*RSNS/2.

Figure 5b shows the terminal voltages V11, V12, V12, V22 at the terminals 11, 12 of the first resistor 10 and at the terminals 12, 22 of the second resistor 20.When adding the signals at the first terminals and the signals at the second terminals similar disturbances apply at both amplifier inputs 201, 202 and are cancelled out when amplifying the difference voltage at the amplifier inputs 201, 202. The summed voltages at the summing nodes V((11+21)/2) and V((12+22)/2) are similar but inverse as indicated in Figure 5b. The differential voltage V((11+21)-(12+22)) shows measured current. The common-mode voltage V((11+21+12+22)/4) is cancelled out forming a straight line.

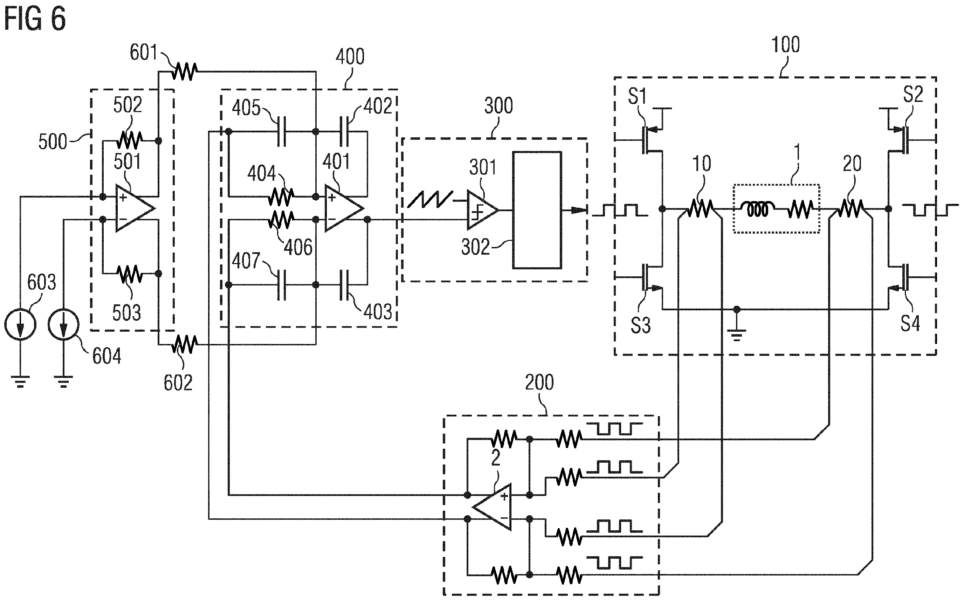

Figure 6 shows an embodiment of a loop configuration comprising the H-bridge block 100 and the sense amplifier block 200 decribed in Figure 4.

The loop comprises an input block 500, an error amplifier block 400 downstream of the input block 500, a pulse-width modulation (PWM) block 300 downstream of the error amplifier block 400 and the H-bridge block 100 downstream of the PWM block 300. A feedback loop is formed by the sense amplifier block 200 coupled between the H-bridge block 100 and the error amplifier block 400.

The H-bridge block 100 drives the load 1 by means of the switching transistors S1, S2, S3, S4, which are controlled by the PWM block 300, providing signals for switching the switching transistors S1, S2, S3, S4. The PWM block 300 comprises a comparator 301 providing a signal for a control device 302 for the switching transistors S1, S2, S3, S4. In dependence of the comparator's signal the switching process may be amended e.g. by amending the timing. At the input of the comparator 301 a sawtooth wave signal and the output of the error amplifier block 400 are applied.

The error amplifier block 400 gets its input from the input block 500 and the feedback loop including the sense amplifier block 200. The error amplifier block 400 includes an amplifier 401 having two inputs and two outputs. One input is coupled with one output by a capacitor 402. The other input is coupled with the other output by a further capacitor 403. The inputs are coupled with the outputs of the sense amplifier block 200 by a resistor 404, 406 and a capacitor 405, 407 in parallel each. Input signals of the input block 500 are coupled to the inputs of the amplifier 401 via resistors 601, 602.

The input block 500 serves as a current-to-voltage converter comprising an amplifier 501 having two inputs and two outputs. One input is coupled with one output by a resistor 502. The other input is coupled with the other output by a further resistor 503. The inputs are connected with current digital-to-analog converters IDAC 603, 604.

The loop allows to regulate the operation of the load 1 by monitoring the current travelling through load 1 and using it as an input for the control of the H-bridge.

The scope of protection is not limited to the examples given herein above. The invention is embodied in each novel characteristic and each combination of characteristics, which particularly includes every combination of any features which are stated in the claims, even if this feature or this combination of features is not explicitly stated in the claims or in the examples.

**Reference numerals**

| | |
|---|---|
| 1 | load |
| 2, 301, 401, 501 | amplifier |
| 9, 10, 20, 30, 40, 50, 60, 70, 80, RL, 404, 406, 502, 503, 601, 602 | resistor |
| 5, 6 | connector |
| 11, 12, 21, 22, 91, 92, 201, 202, 203, 204 | terminal |
| 51, 52 | leg |
| 53 | bridge branch |
| 100, 200, 300, 400, 500 | block |
| 301 | comparator |
| 302 | control device |
| 402, 403, 405, 407 | capacitor |
| 603, 604 | current source |
| LL | inductance |
| PS1, PS2 | summing node |
| S1, S2, S3, S4 | switching transistor |
| V11, V12, V21, V22, V(11-12), V(21-22), V((11+21) /2), V((12+22) /2), V((11+21)-(12+22)), V((11+21+12+22)/4) | voltage |
| VDD, GND, P1, P2 | node |
| X, X1, X2, X10, X20, X11, X12, X21, X22 | signal |

## Claims

1. Current sense circuit arrangement for a load (1) arranged in a bridge branch (53) coupled between two legs (51, 52) of an H-bridge comprising two high-side switching transistors (S1, S2) and two low-side switching transistors (S3, S4); the current sense circuit arrangement comprising
- a first resistor (10) and a second resistor (20), the first resistor (10) being arranged upstream of the load (1) or load connectors (5, 6), between which the load (1) is connectable, in the bridge branch, the second resistor (20) being arranged downstream of the load (1) or load connectors, between which the load (1) is connectable, in the bridge branch, and
- summing means for adding a first voltage across the first resistor (10) and a second voltage across the second resistor (20) .

2. Current sense circuit arrangement according to claim 1, wherein the first resistor (10) has a first terminal (11) and a second terminal (12) and the second resistor (20) has a first terminal (21) and a second terminal (22); the second terminal (12) of the first resistor (10) being coupled with the load (1) or one of the load connectors (5, 6); the first terminal (21) of the second resistor (20) being coupled with the load (1) or one of the load connectors (5, 6).

3. Current sense circuit arrangement according to claim 2, wherein the bridge branch (53) comprises
a first potential node (P1), which is arranged in a first leg (51) of the H-bridge comprising one of the two high-side switching transistors (S1, S2) and one of the two low-side switching transistors (S3, S4), and
a second potential node (P2), which is arranged in a second leg (52) of the H-bridge comprising the other one of the two high-side switching transistors (S1, S2) and the other one of the two low-side switching transistors (S3, S4);
the first terminal (11) of the first resistor (10) being coupled with the first potential node (P1); the second terminal (22) of the second resistor (20) being coupled with the second potential node (P2).

4. Current sense circuit arrangement according to any of the preceding claims,
wherein the first resistor (10) has the same or nearly the same resistance value as the second resistor (20).

5. Current sense circuit arrangement according to any of claims 2 to 4,
wherein the summing means comprises a first summing node (PS1) coupled with the first terminals (11, 21) of the first and second resistors (10, 20) and a second summing node (PS2) coupled with the second terminals (12, 22) of the first and second resistors (10, 20).

6. Current sense circuit arrangement according to claim 5, wherein the summing means comprises a differential amplifier (2) having first and second input terminals (201, 202) that are coupled with the first and second summing nodes (PS1, PS2) or embodied as the first and second summing nodes (PS1, PS2) .

7. Current sense circuit arrangement according to claim 6, wherein the differential amplifier (2) is suitable for providing a amplified difference of the sum of voltages at the first terminals (11, 21) and the sum of voltages at the second terminals (12, 22).

8. Current sense circuit arrangement according to claim 6 or 7,
wherein a third resistor (30) is coupled between the first terminal (21) of the second resistor (20) and the first summing node (PS1),
and a fourth resistor (40) is coupled between the first terminal (11) of the first resistor (10) and the first summing node (PS1),
and a fifth resistor (50) is coupled between the second terminal (12) of the first resistor (10) and the second summing node (PS2),
and a sixth resistor (60) is coupled between the second terminal (22) of the second resistor (20) and the second summing node (PS2).

9. Current sense circuit arrangement according to any of claims 6 to 8,
wherein the differential amplifier (2) has a first output terminal (203) and a second output terminal (204);
the first input terminal (201) being coupled with the first output terminal (203) via a seventh resistor (70); the second input terminal (202) being coupled with the second output terminal (204) via an eighth resistor (80).

10. Loop arrangement comprising
an H-bridge including the current sense circuit arrangement according to any of the preceding claims, wherein an output (203, 204) of the summing means is coupled via an error amplifier means (400) to a pulse-width modulator means (300) controlling the switches (S1, S2, S3, S4) of the H-bridge in dependence of the output of the summing means (203, 204).

11. A method for sensing a current in an H-bridge wherein a bridge branch (53) is arranged between two legs (51, 52) of the H-bridge comprising two high-side switching transistors (S1, S2,) and two low-side switching transistors (S3, S4), a first resistor (10) being arranged upstream of the load (1) in the bridge branch (53) and a second resistor (20) being arranged downstream of the load (1) in the bridge branch; the method comprising:
- detecting a first voltage across the first resistor (10),
- detecting a second voltage across the second resistor (20),
- summing the first voltage across the first resistor (10) and the second voltage across the second resistor (20).

12. The method according to claim 11,
wherein the first resistor (10) has a first terminal (11) and a second terminal (12) and the second resistor (20) has a first terminal (21) and a second terminal (22); the second terminal (12) of the first resistor (10) being coupled with the load (1); the first terminal (21) of the second resistor (20) being coupled with the load (1);
wherein summing includes
- summing the voltages at the first terminals (11, 21),
- summing the voltages at the second terminals (12, 22),
- providing a amplified difference of the sum of the voltages at the first terminals (11, 21) and the sum of the voltages at the second terminals (12, 22).

13. The method according to claim 12,
wherein summing the voltages at the first terminals (11, 21) includes converting the voltages into proportional currents and adding them,
wherein summing the voltages at the second terminals (12, 22) includes converting the voltages into proportional currents and adding them,
wherein providing a amplified difference of the sums includes converting the added currents into proportional voltages and providing the amplified difference of the proportional voltages by means of a differential amplifier.
